(19) Europäisches Patentamt
European Patent Office
Office européen des brevets

(11) EP 2 637 310 B1

(12) **FASCICULE DE BREVET EUROPEEN**

(45) Date de publication et mention
de la délivrance du brevet:
**21.01.2015 Bulletin 2015/04**

(21) Numéro de dépôt: **13354010.4**

(22) Date de dépôt: **06.03.2013**

(51) Int Cl.:
***H03K 19/21*** *(2006.01)*   ***G06F 9/38*** *(2006.01)*

(54) **Circuit asynchrone insensible aux délais**

Verzögerungsunempfindlicher asynchroner Schaltkreis

Asynchronous circuit that is not sensitive to delays

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **06.03.2012 FR 1200670
06.03.2012 FR 1200669**

(43) Date de publication de la demande:
**11.09.2013 Bulletin 2013/37**

(73) Titulaire: **Tiempo
F-38330 Montbonnot St-Martin (FR)**

(72) Inventeurs:
• **Renaudin, Marc**
**38330 Biviers (FR)**
• **Nguyen van Mau, David**
**38170 Seyssinet Pariset (FR)**

(74) Mandataire: **Hecké, Gérard et al
Cabinet Hecké
10 rue d'Arménie - Europole
BP 1537
38025 Grenoble Cedex 1 (FR)**

(56) Documents cités:
JP-A- 2002 164 779    US-A- 4 845 633
US-A1- 2003 095 556

## Description

### Domaine technique de l'invention

L'invention est relative à la conception de circuits asynchrones, et plus particulièrement à des circuits asynchrones dont le fonctionnement est garanti indépendamment des délais de propagation.

### État de la technique

A la différence d'un circuit synchrone, un circuit asynchrone comme décrit par exemple dans le document US 4,845,633 n'utilise pas de signal d'horloge global pour synchroniser l'exécution de ses composants. Les composants du circuit asynchrone se synchronisent localement, en utilisant un protocole de communication de type requête et acquittement. Toute transmission d'information entre un composant émetteur et un composant récepteur doit être acquittée par le récepteur pour que l'émetteur puisse transmettre à nouveau.

Le protocole le plus utilisé est le protocole à quatre phases, appelé également protocole « retour à zéro » (« four-phase handshake » en anglais). Les différentes phases du protocole sont les suivantes :

- l'émetteur envoie une donnée au récepteur ;

- le récepteur détecte la donnée, effectue le traitement auquel il est destiné et génère un signal d'acquittement ;

- l'émetteur détecte le signal d'acquittement et invalide la donnée ; et

- le récepteur détecte l'état invalide de la donnée et désactive le signal d'acquittement.

L'émetteur détecte l'état inactif du signal d'acquittement et peut alors émettre une nouvelle donnée (si celle-ci est disponible), ce qui marque le début d'un nouveau cycle de communication.

On distingue plusieurs classes de circuits asynchrones. Celles-ci sont définies en fonction des hypothèses temporelles que les circuits asynchrones doivent respecter.

Les circuits asynchrones insensibles aux délais ne font aucune hypothèse temporelle. Leur fonctionnement correct est indépendant des délais de propagation des signaux dans les portes logiques et dans les fils qui relient ces portes. En pratique, leur utilisation est limitée car toutes les fonctions logiques ne peuvent être réalisées avec des éléments logiques à une seule sortie. En effet, les seuls composants à une sortie véritablement insensibles aux délais sont l'inverseur et la porte de Muller (ou « C-element ») à plusieurs entrées dont la table logique est donnée ci-dessous :

| b＼a | 0 | 1 |
|---|---|---|
| 0 | 0 | $s^{-1}$ |
| 1 | $s^{-1}$ | 1 |

La sortie s d'une porte de Muller à deux entrées a et b, recopie les entrées a et b lorsque celles-ci sont identiques. Lorsque les entrées a et b diffèrent, la sortie s reste dans son état précédent ($s^{-1}$).

La classe des circuits quasi-insensibles aux délais introduit l'hypothèse temporelle de fourche isochrone. La notion de fourche isochrone est l'hypothèse minimale requise pour pouvoir réaliser n'importe quelle fonction logique à base d'éléments logiques à une seule sortie. Une fourche est un fil qui connecte un émetteur à au moins deux portes logiques. Une fourche est qualifiée d'isochrone lorsque les temps de propagation entre l'émetteur et chaque porte logique sont supposés identiques.

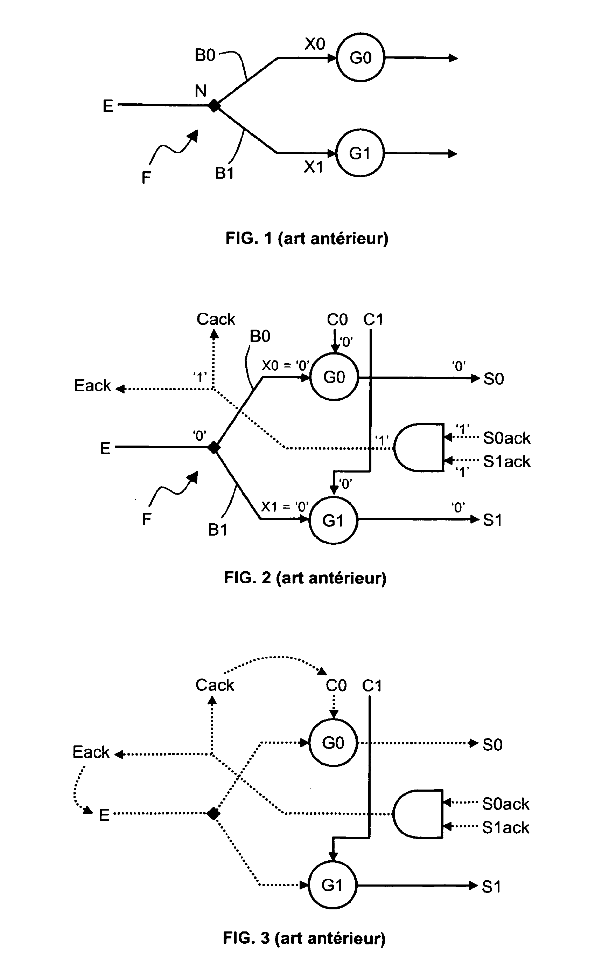

La figure 1 représente à titre d'exemple une fourche isochrone F à deux branches B0 et B1 utilisée dans un circuit asynchrone. Un signal d'entrée E de la fourche est dupliqué dans chacune des branches B0 et B1. L'extrémité de chaque branche B0, B1, opposée au noeud N de la fourche, est connectée à une porte logique G0, G1. Ainsi, les portes G0 et G1 reçoivent respectivement des signaux de fin de branche X0 et X1. Les signaux X0 et X1 sont également appelés terminaux de la fourche.

Par hypothèse, le temps de propagation du signal d'entrée E au terminal X0 dans la branche B0 est égal au temps de propagation du signal E au terminal X1 dans la branche B1. Il est alors possible de ne tester qu'une seule branche et de supposer que le signal s'est propagé de façon similaire dans l'autre branche de la fourche. En effet, par définition d'une fourche isochrone les transitions (montantes ou descendantes) du signal d'entrée E se propagent exclusivement à travers G0 ou G1.

Il s'avère, dans la pratique, que cette condition d'égalité des temps de propagation est trop forte et que la correction fonctionnelle du circuit asynchrone autorise une différence de délais entre les branches. En d'autres termes, le circuit reste fonctionnel tant que la différence de délais entre les branches ne dépasse pas une valeur maximale. On appelle cette différence maximale le mou ou la marge temporelle (« slack » en anglais).

Les figures 2 à 7 illustrent la notion de mou dans un exemple simple de circuit asynchrone. Ce circuit réalise une fonction de démultiplexage et ne comporte qu'une seule fourche isochrone.

Le circuit comprend une fourche isochrone F à deux branches B0 et B1, telle que décrite en relation avec la figure 1. Les portes logiques G0 et G1 sont ici des portes de Muller à deux entrées et une sortie. Chaque porte G0, G1 reçoit en entrée le signal de fin de branche X0, X1 et un signal de sélection C0, C1. Les signaux en sortie des portes logiques G0 et G1 sont notés respectivement S0 et S1.

Dans cet exemple, la fourche F est placée dans le chemin de données. Elle propage un signal de données E provenant d'un émetteur, placé en amont de la fourche F, vers deux récepteurs disposés en aval des portes logiques G0, G1. Par souci de clarté, l'émetteur et les récepteurs ne sont pas représentés sur les figures 2 à 7.

Le circuit comprend en outre une porte « ET » placée dans le chemin d'acquittement, des récepteurs vers l'émetteur. Les signaux S0ack et S1ack, en entrée de la porte « ET », sont les signaux d'acquittement des sorties S0 et S1. La sortie de la porte « ET » véhicule les signaux d'acquittement Eack et Cack, qui permettent de formuler une requête à l'émetteur.

La fonction de démultiplexage réalisée par ce circuit a pour but de synchroniser le signal E et l'un des signaux de sélection C0, C1, et de diriger le signal E vers la sortie sélectionnée. Comme les signaux C0 et C1 sont mutuellement exclusifs, l'autre sortie est passive et reste dans un état inactif.

La figure 2 correspond à un état initial du circuit. Les signaux du chemin de données, en entrée (E), en fin de branches (X0 et X1) et en sorties des portes logiques (S0 et S1), sont dans un état logique bas (niveau logique '0'). Les signaux de sélection C0 et C1 sont également à l'état bas. A l'inverse, les signaux du chemin d'acquittement S0ack, S1ack, Eack et Cack sont initialement dans un état logique haut ('1').

Les figures 3 à 6 représentent l'état du circuit dans chacune des quatre phases du protocole de communication. Les traits pleins symbolisent les fils véhiculant des signaux à '0' et les traits pointillés symbolisent des fils véhiculant des signaux à '1'.

A la figure 3, l'état haut des signaux d'acquittement Eack et Cack indique à l'émetteur qu'une nouvelle donnée peut être envoyée. Le signal d'entrée E passe alors de '0' à '1'. L'un des signaux de sélection, ici C0, passe aussi à '1'. Les entrées de la porte de Muller G0 valant toutes les deux '1', le signal de sortie S0 passe également à '1'.

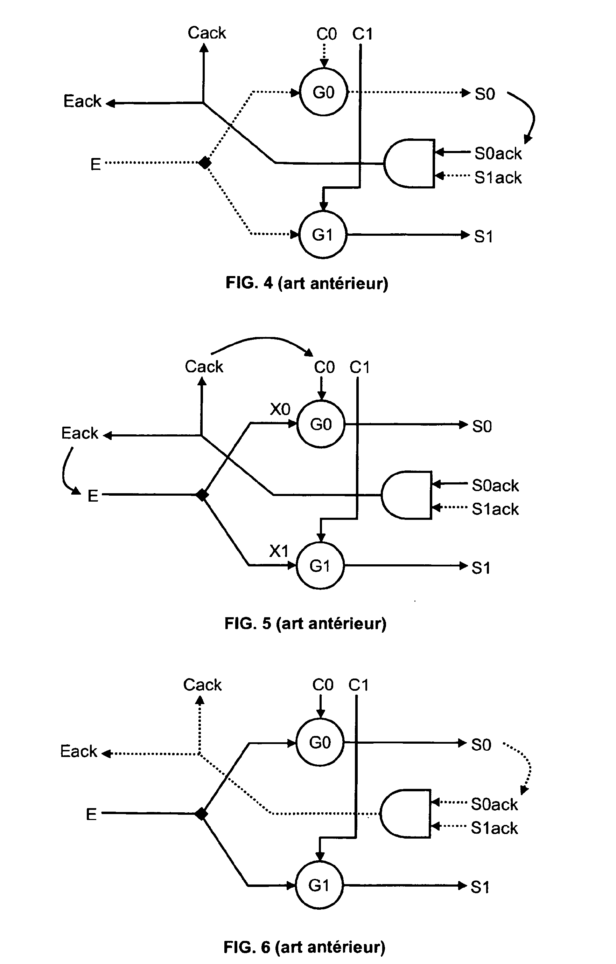

A la figure 4, le récepteur détecte le changement d'état de S0 et accuse réception en faisant passer le signal S0ack à '0'. Les signaux Eack et Cack en sortie de la porte « ET » passent alors à '0' (Eack = Cack = S0ack.S1ack).

L'émetteur, voyant les signaux d'acquittement activés, invalide les données (Fig.5). Le signal d'entrée E et le signal de sélection C0 repassent tous les deux à '0'. La transition du signal E, de '1' à '0', se propage dans la fourche, jusqu'aux terminaux X0 et X1, puis en sortie S0 de la porte de Muller G0 (S1 étant déjà à '0').

A la figure 6, le récepteur détecte l'état invalide des données en S0 et désactive le signal d'acquittement S0ack, qui repasse à '1'. Les signaux Eack et Cack passent également à '1', ce qui a pour effet de demander l'envoi d'une nouvelle donnée. Le circuit est alors revenu dans son état initial.

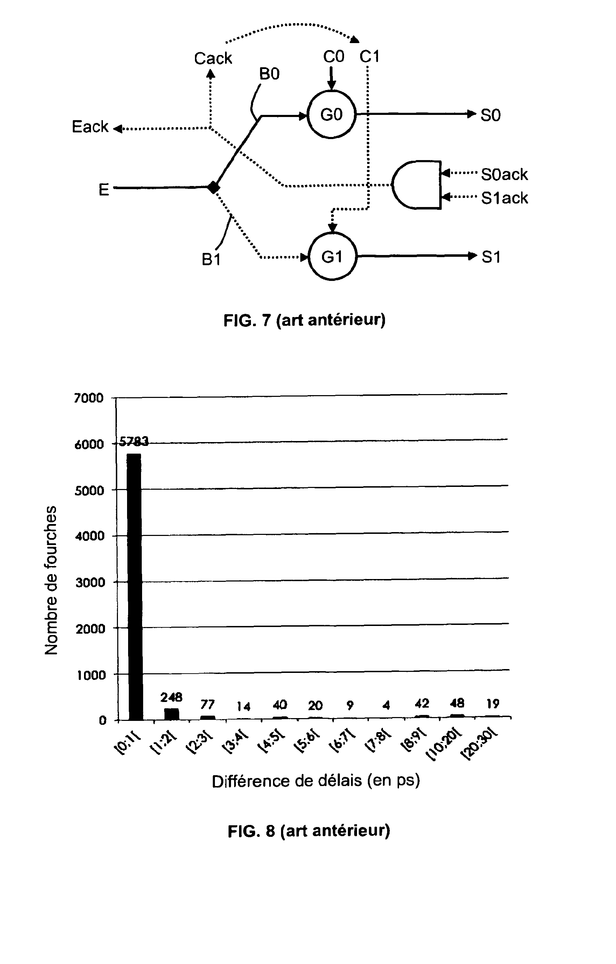

La figure 7 illustre maintenant le comportement erroné du circuit lorsque la différence de délais entre les branches est trop importante (égalité ou quasi-égalité des délais non respectée).

On suppose pour cela que la branche B1 de la fourche est bien plus lente que la branche B0. A l'étape de la figure 5, la transition de '1' à '0' du signal E ne se propagera pas immédiatement dans la branche B1. Or, lorsqu'une nouvelle donnée sera réclamée (à l'étape de la figure 6), l'activation du signal C1 aura pour conséquence le basculement prématuré de la porte G1 avant même que la nouvelle donnée E ait commencé à se propager dans la fourche (Fig.7).

Ce dysfonctionnement du circuit pourra être observé à chaque fois que la dispersion de délais entre les branches B0, B1 est supérieure au mou, c'est-à-dire au temps nécessaire pour observer l'état invalide de S0 (Fig. 5), l'état inactif du signal d'acquittement S0ack (Fig.6) et l'activation du signal de sélection C1 (Fig.7).

Le mou dépend du circuit que l'on examine car il est égal à la somme des temps de propagation du signal dans chaque élément du circuit (fils, portes logiques, récepteur et émetteur).

La figure 8 représente la répartition des fourches isochrones d'un circuit asynchrone plus complexe (environ 6000 fourches isochrones), en fonction de la dispersion de délais dans ces fourches.

On constate que la grande majorité des fourches isochrones ont une dispersion de délais inférieure à 1 ps. Par contre, un certain nombre de fourches ont une dispersion élevée, jusqu'à 30 ps. Ces fourches représentent un risque de disfonctionnement si le mou est inférieur à 30 ps dans ce type de circuit. Or, il suffit d'une seule branche qui ne respecte pas le mou pour que le circuit ne soit pas opérationnel.

Les délais de propagation dans une fourche isochrone sont susceptibles de varier lors du fonctionnement du circuit, par exemple sous l'effet de la température ou de la pression. La dispersion de délais entre les branches peut donc augmenter dans le temps. Elle peut même varier d'un circuit à l'autre, à cause de la fluctuation du processus de fabrication. Il convient donc de concevoir des circuits qui tolèrent ces variations de délais.

## Résumé de l'invention

On constate qu'il existe un besoin de prévoir un circuit asynchrone plus robuste aux variations de délais dans une fourche isochrone.

On tend à satisfaire ce besoin en prévoyant dans le circuit asynchrone une fourche à au moins deux branches, chaque branche étant connectée à une porte logique de sorte que la porte logique reçoive en entrée un signal de fin de branche, un circuit de dérivation du signal de fin de branche au niveau de chaque porte logique pour former un signal dérivé, et un circuit de blocage comprenant une porte de Muller et recevant en entrée au moins un signal dérivé. Le circuit de blocage est configuré pour empêcher la propagation d'un signal de sortie lorsque les signaux de fin de branche sont dans des états logiques différents.

Le circuit de blocage est de préférence distinct de chaque porte logique.

Dans un premier mode de réalisation de l'invention, le circuit de blocage reçoit en entrée tous les signaux de fin de branche dont au moins un est dérivé par un circuit de dérivation.

Selon un développement, le circuit de blocage reçoit en entrée tous les signaux dérivés et un signal à bloquer, le signal de sortie étant un signal d'acquittement.

Dans un deuxième mode de réalisation de l'invention, le circuit asynchrone comprend un circuit de blocage pour chaque porte logique, chaque circuit de blocage comprenant une porte de Muller et recevant en entrée le signal dérivé associé à la porte logique et un signal de données à bloquer, la sortie du circuit de blocage étant reliée à une entrée de la porte logique.

L'invention vise également un procédé permettant de réduire la sensibilité aux délais d'un circuit asynchrone. Le procédé comprend les étapes suivantes :

- sélectionner une première fourche isochrone ayant un premier niveau de dangerosité et comprenant au moins deux branches connectées chacune à une porte logique ;

- introduire un circuit de dérivation du signal de fin de branche au niveau de chaque porte logique pour former un signal dérivé ; et

- prévoir un circuit de blocage comprenant une porte de Muller et recevant en entrée au moins un signal dérivé, le circuit de blocage étant configuré pour empêcher la propagation d'un signal de sortie lorsque les signaux de fin de branche sont dans des états logiques différents.

Selon un développement du procédé, on sélectionne une deuxième fourche isochrone ayant un deuxième niveau de dangerosité, inférieur au premier niveau de dangerosité, la deuxième fourche isochrone comprenant au moins deux branches connectées chacune à une porte logique, et on dispose les portes logiques associées à la deuxième fourche dans une zone restreinte du circuit, de manière à limiter la dispersion des délais de propagation entre les branches de la deuxième fourche.

**Description sommaire des dessins**

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1 est le schéma classique d'une fourche isochrone dans un circuit asynchrone ;

- la figure 2 est le circuit logique d'une fonction de démultiplexage selon l'art antérieur ;

- les figures 3 à 6 représentent le circuit de démultiplexage de la figure 2, dans les quatre phases d'un protocole de communication de type requête et acquittement ;

- la figure 7 représente un exemple de dysfonctionnement du circuit de démultiplexage de la figure 2 ;

- la figure 8 représente la répartition des fourches isochrones d'un circuit asynchrone selon l'art antérieur, en fonction de la dispersion temporelle de ses fourches ;

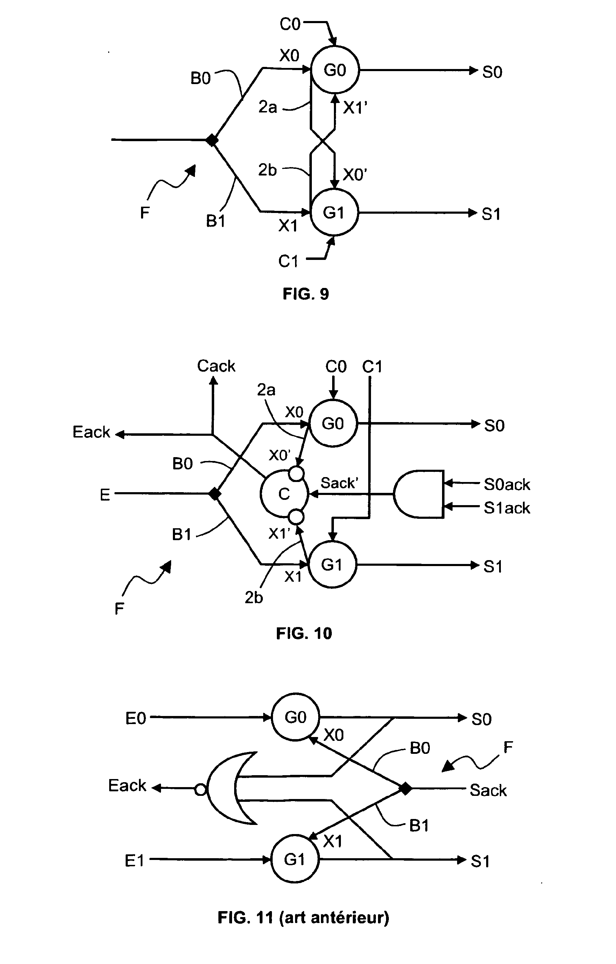

- les figures 9 et 10 représentent deux modes de réalisation d'une fonction de démultiplexage, d'après une première technique de conception de circuit asynchrone selon l'invention ;

- la figure 11 représente le circuit logique d'une fonction de mémorisation selon l'art antérieur ;

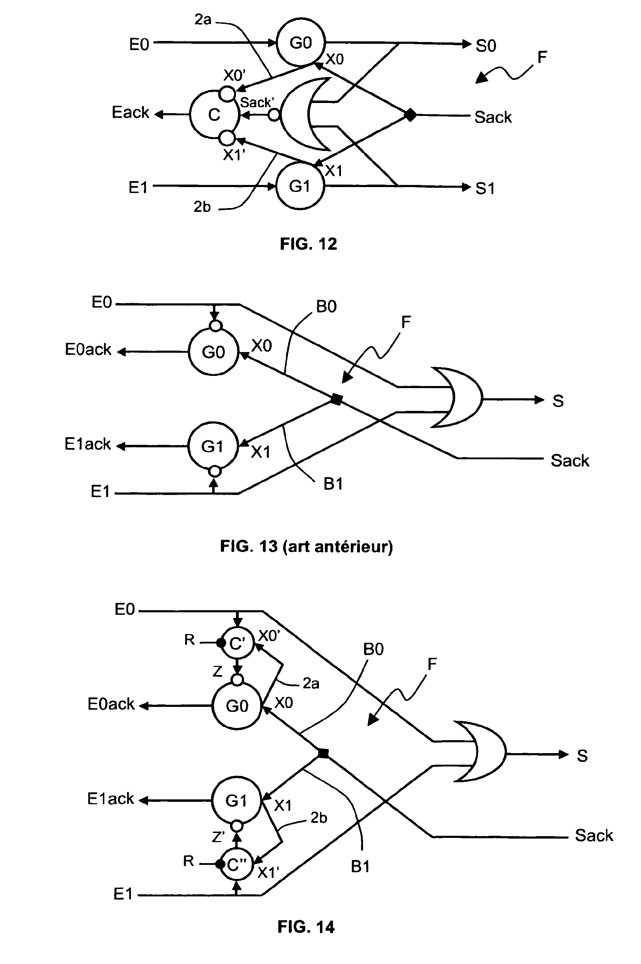

- la figure 12 représente le circuit logique d'une fonction de mémorisation, d'après la première technique de conception de circuit asynchrone selon l'invention ;

- la figure 13 représente le circuit logique d'une fonction de fusion selon l'art antérieur ;

- la figure 14 représente le circuit logique d'une fonction de fusion, d'après la première technique de conception de circuit asynchrone selon l'invention ;

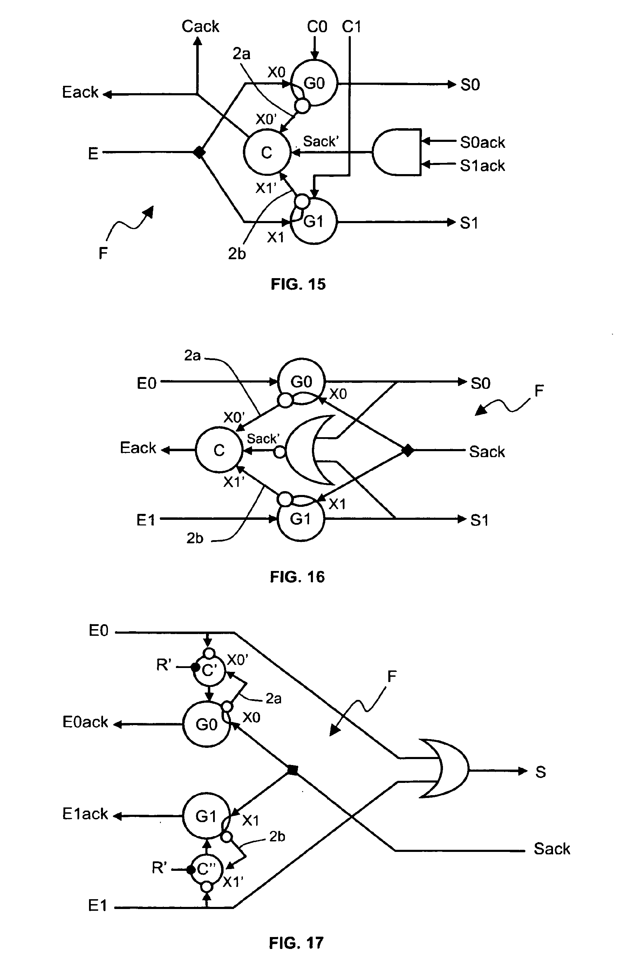

- les figures 15 à 17 représentent un mode de réalisation préférentiel des fonctions logiques des figures 10, 12 et 14 ;

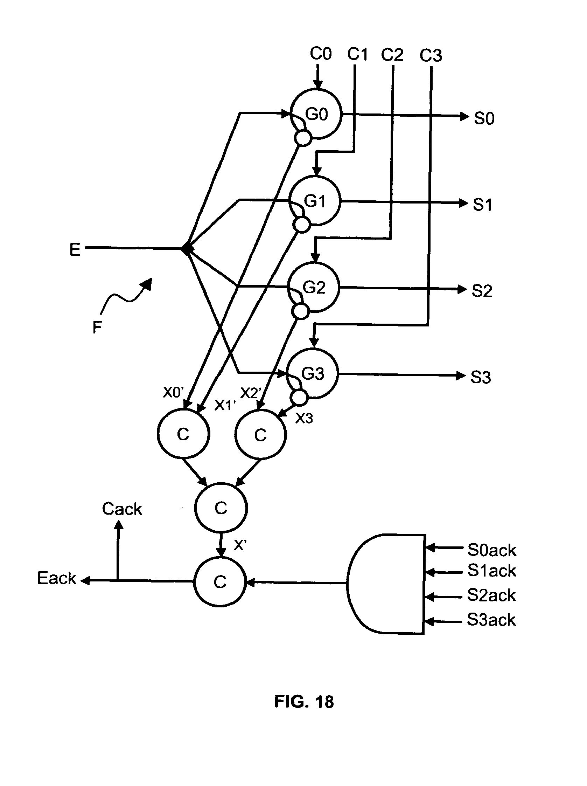

- la figure 18 représente un circuit logique d'une fonction de démultiplexage selon l'invention, muni d'une fourche à quatre branches ;

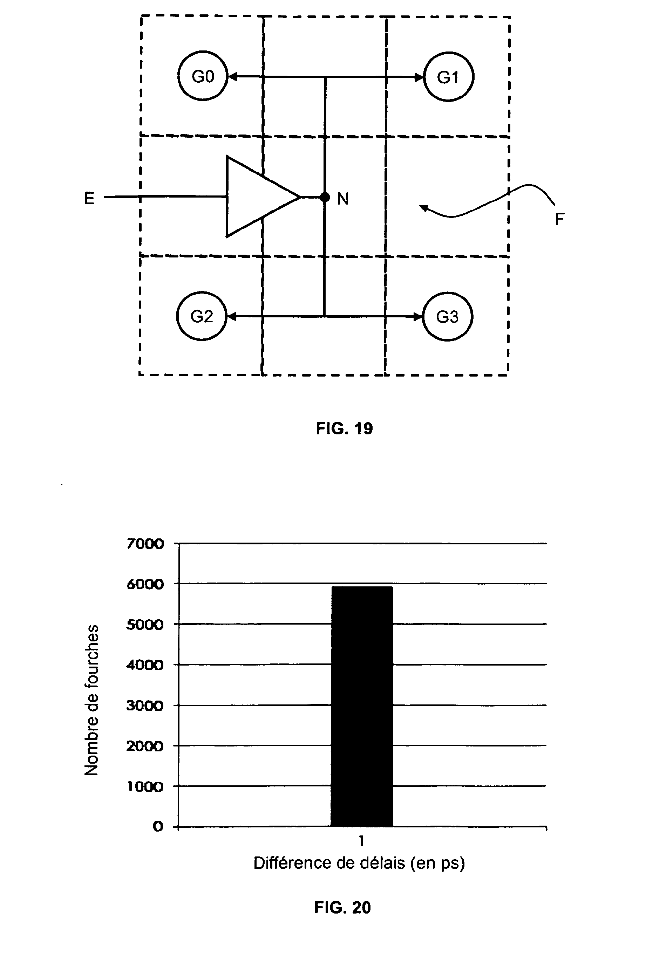

- la figure 19 représente l'agencement d'une fourche isochrone, d'après une deuxième technique de conception de circuit asynchrone selon l'invention ; et

- la figure 20 représente la répartition des fourches isochrones d'un circuit asynchrone conçu selon la deuxième technique de l'invention, en fonction de la dispersion temporelle de ses fourches.

## Description d'un mode de réalisation préféré de l'invention

On décrit ci-après deux techniques de conception d'un circuit asynchrone qui permettent d'augmenter sa robustesse vis-vis des délais de propagation. Ces techniques visent à lever l'hypothèse temporelle de fourche isochrone.

On prévoit, dans l'une de ces techniques, de bloquer la propagation des signaux dans le circuit asynchrone lorsque les signaux de fin de branche, ou terminaux, sont dans des états logiques différents. On évite ainsi tout dysfonctionnement du circuit causé par une dispersion de délais trop importante entre les branches.

En d'autres termes, lorsqu'une transition logique en entrée de la fourche ne s'est pas propagée jusqu'au terminal d'une de ses branches, un nouvel événement, tel que l'envoi d'une nouvelle donnée par l'émetteur, ne peut être généré. Cet événement est retardé tant que la transition n'a pas atteint le terminal de la branche la plus lente.

Tous les circuits présentés ci-après mettent en oeuvre un protocole de communication à quatre phases entre un émetteur et un récepteur. Ils comprennent au moins une fourche isochrone. Cette fourche est caractérisée par le fait qu'une seule des portes logiques connectées à ses branches commute à chaque propagation du signal d'entrée de la fourche.

Dans un premier mode de réalisation de circuit asynchrone robuste, un circuit de dérivation du signal en fin de branche est disposé au niveau de chaque porte logique de la fourche. Chaque circuit de dérivation recopie le terminal d'une branche puis le « dérive » en entrée des portes logiques disposées dans les autres branches. Les portes logiques ne reçoivent donc plus un seul terminal, mais tous les terminaux de la fourche.

Dans la description qui suit, l'expression « signal dérivé » pourra désigner soit une copie conforme d'un signal, comme dans ce premier mode de réalisation, soit une copie inversée de ce signal.

La figure 9 représente un exemple de circuit asynchrone selon le premier mode de réalisation. On a repris pour cet exemple le circuit de la figure 2 qui met en oeuvre une fonction de démultiplexage, en y retirant toutefois son circuit d'acquittement.

Le circuit de démultiplexage, dénommé ci-après « DMUX », comprend comme précédemment une fourche F à deux branches B0, B1 et deux portes de Muller G0, G1. Chaque porte G0, G1 reçoit en entrée deux signaux, le terminal X0, X1 de la branche à laquelle elle est connectée et un signal de sélection C0, C1.

Le circuit DMUX comprend en outre deux circuits de dérivation 2a et 2b. Chaque circuit de dérivation est formé d'un fil de connexion supplémentaire entre les deux portes. La connexion 2a duplique le terminal X0 en un signal X0' et le dirige vers une troisième entrée de la porte G1. De même, la connexion 2b copie le signal X1 et achemine le signal copié X1' vers une troisième entrée de la porte G0. Dans cet exemple, les portes G0 et G1 sont donc des portes de Muller à trois entrées et deux sorties, une sortie de données S0, S1 et une sortie à laquelle est connectée le circuit de dérivation 2a, 2b.

Ainsi, la porte G0 reçoit en entrée le terminal X0 et le terminal X1 par l'intermédiaire du circuit de dérivation 2b, et la porte G1 reçoit en entrée le terminal X1 et le terminal X0 par l'intermédiaire du circuit de dérivation 2a.

Les portes de Muller G0 et G1 font office de circuits de blocage dans le circuit asynchrone, en vérifiant l'état logique de tous les terminaux. Le signal de sortie S0 ou S1 (selon le signal C0 ou C1 choisi) est généré seulement lorsque les terminaux X0 et X1 sont dans le même état.

Les circuits de dérivation 2a et 2b garantissent le fonctionnement du circuit asynchrone quelque soit les délais de propagation dans les branches de la fourche. En contrepartie, le circuit est sensiblement plus lent puisqu'il est nécessaire d'attendre la commutation de tous les terminaux pour générer S0 ou S1, ce qui n'était pas le cas avant.

Ce circuit est particulièrement simple à mettre en oeuvre puisqu'il suffit de prévoir, lors de sa conception, des connexions supplémentaires entre les portes logiques G0 et G1. Par contre, la complexité du circuit croit rapidement avec le nombre de branches. En effet, le nombre de fils et d'entrées supplémentaires dans les portes logiques est égal à $n.(n-1)$ pour une fourche à $n$ branches ($n \geq 2$).

Ce premier mode de réalisation sera donc, en pratique, limité aux fourches avec un nombre restreint de branches et utilisé dans les circuits asynchrones où la vitesse n'est pas un paramètre critique.

Dans un deuxième mode de réalisation de circuit asynchrone, on vise à garantir le fonctionnement du circuit vis-à-vis de la dispersion de délais entre les branches, sans accroître la complexité du circuit ni diminuer sa vitesse de façon significative.

A cet effet, on prévoit, en plus des circuits de dérivation 2a et 2b, un circuit de blocage muni d'au moins une porte de Muller distincte des portes G0 et G1.

La figure 10 représente le circuit de démultiplexage DMUX selon ce deuxième mode de réalisation. Le circuit d'acquittement, muni de sa porte « ET », est cette fois représenté.

Le circuit DMUX comprend un circuit de blocage disposé dans le chemin d'acquittement. Le circuit de blocage est, dans ce mode de réalisation, formé d'une porte de Muller C et deux inverseurs accolés à la porte C. Chaque inverseur reçoit en entrée un des signaux X0' et X1', dérivés par les circuits 2a et 2b. Les signaux dérivés X0' et X1' sont ici aussi des copies des terminaux X0 et X1. La sortie de chaque inverseur est directement connectée à une entrée de la porte de Muller C. La porte C reçoit donc des copies inversées des terminaux X0 et X1de la fourche.

Par ailleurs, la porte C comporte une troisième entrée connectée à la sortie de la porte « ET ». La porte C reçoit alors un signal d'acquittement Sack' qui correspond au produit des signaux d'acquittement de sortie S0ack et S1ack. La sortie de la porte C correspond aux signaux d'acquittement Eack et Cack à destination de l'émetteur ou des émetteurs (non représentés).

Dans le circuit de la figure 10, la porte de Muller C bloque la propagation du signal d'acquittement Sack' lorsque les terminaux de la fourche sont dans des états logiques différents. La transition des signaux d'acquittement Eack et Cack et l'envoi d'une nouvelle donnée par l'émetteur sont alors retardés. Par conséquent, le déclenchement prématuré de la porte logique associée à la branche la plus lente, décrit en relation avec la figure 7, ne peut plus se produire.

La figure 11 est un autre exemple de fonction logique couramment employée dans un circuit asynchrone, celle de mémoire « tampon ».

Le circuit de mémorisation de la figure 11, appelé ci-après « BUFFER », comprend une fourche F munie de deux branches B0, B1 et de deux portes de Muller G0, G1. Chaque porte G0, G1 reçoit en entrée, en plus du terminal X0, X1 de la branche qui lui est associée, un signal E0, E1 d'une donnée à mémoriser.

Le circuit BUFFER comprend en outre une porte « NON-OU » dont les signaux d'entrée correspondent aux signaux de sortie S0 et S1 des portes G0 et G1. Le signal de sortie de la porte « NON-OU » constitue le signal d'acquittement Eack.

On peut remarquer que, dans cet exemple, la fourche F n'est plus placée dans le chemin de données mais dans le chemin d'acquittement. En entrée de la fourche, on n'a donc plus un signal de données E mais un signal d'acquittement Sack provenant du récepteur.

Les signaux d'entrée E0 et E1 étant mutuellement exclusifs, une seule des deux données est mémorisée. Autrement dit, une seule des sorties S0 et S1 recopie la donnée E0 ou E1. Dès lors, on peut prévoir un signal d'acquittement Sack commun aux deux sorties S0 et S1.

La figure 12 représente le circuit de la fonction mémoire après y avoir introduit les circuits de dérivation 2a, 2b et le circuit de blocage, afin de le rendre plus robuste aux variations de délais.

Comme précédemment, le circuit de blocage peut être formé d'une seule porte de Muller C associée à deux inverseurs. La porte C reçoit des copies inversées des terminaux (par l'intermédiaire des signaux dérivés X0' et X1') et un signal d'acquittement Sack' dont on bloquera la progression lorsque les terminaux ne sont pas dans le même état logique.

Ainsi, dans les cas des circuits DMUX (Fig.10) et BUFFER (Fig.12), le circuit de blocage reçoit en entrée les signaux dérivés de tous les terminaux et comprend une porte de Muller dont le signal de sortie permet l'acquittement des données (Eack).

Ces solutions sont bien moins complexes que celle de la figure 9 car la porte de Muller C centralise tous les signaux dérivés. Le nombre d'entrées supplémentaires à prévoir est égal au nombre de branches (*n*) de la fourche plus une entrée pour le signal d'acquittement à bloquer, Sack' (soit *n+1* entrées supplémentaires dans le circuit asynchrone).

En outre, la pénalité en vitesse des circuits DMUX et BUFFER est réduite au maximum. En effet, elle est nulle dans le chemin de données car la transition du signal S0 ou S1 n'est jamais retardée. Le traitement du signal S0 ou S1 par le récepteur peut donc se poursuivre. Dans le chemin d'acquittement, la pénalité en vitesse est égale au temps de propagation dans une seule porte : la porte C.

La figure 13 est un troisième exemple de fonction logique couramment employée dans les circuits asynchrones. Cette fonction permet d'additionner ou fusionner deux signaux d'entrée E0 et E1 en un seul signal de sortie S, les signaux E0 et E1 étant mutuellement exclusifs. Son circuit est dénommé ci-dessous « MERGE ».

Le circuit MERGE comporte une porte « OU » qui regroupe les signaux de données E0 et E1, et en parallèle, une fourche F à deux branches B0 et B1. Comme dans le cas du circuit BUFFER, la fourche F se situe dans le chemin d'acquittement. Elle propage un signal d'acquittement Sack de la sortie S.

Dans cette réalisation particulière de la fonction de fusion, les portes de Muller G0, G1 sont équipées chacune d'un inverseur. Chaque inverseur reçoit un des signaux de données E0 et E1. Ainsi, la porte G0 a pour signaux d'entrée le terminal X0 et une copie inversée du signal de données E0 tandis que la porte G1 reçoit en entrée le terminal X1 et une copie inversée du signal E1.

La figure 14 représente le circuit MERGE selon le deuxième mode de réalisation de l'invention. On a introduit un circuit de blocage entre chaque porte logique G0, G1 et le signal de données E0, E1 associé. On a donc autant de circuits de blocage qu'on a de branches dans la fourche. Le circuit de blocage C', associé à la porte G0, a pour signaux d'entrée le signal de données E0 et le signal X0' dérivé par la connexion 2a. De la même manière, le circuit de blocage C", associé à la porte G1, reçoit en entrée le signal E1 et le terminal dérivé X1'. Les signaux X0' et X1' sont ici des copies conformes des terminaux X0 et X1.

Chaque circuit de blocage C', C" est, dans cet exemple, formé d'une porte de Muller avec remise à zéro. Il s'agit d'une porte de Muller dotée d'un signal de réinitialisation R, qui permet d'initialiser sa sortie Z à '0'. Son équation logique est donnée ci-dessous (dans le cas de la porte C') :

$$Z = R \cdot (X0' \cdot E0 + (X0' + E0) \cdot Z)$$

Le signal de sortie Z, Z' de chaque circuit de blocage C', C" est acheminé vers l'inverseur disposé en entrée de la porte de Muller G0, G1 correspondante. Chaque porte G0, G1 reçoit donc maintenant le terminal X0, X1 de la branche associée et l'inverse du signal de sortie Z, Z' de la porte de Muller C', C" correspondante.

Le blocage intervient au début d'un nouveau cycle de communication « 4 phases », lorsqu'une nouvelle donnée E0 ou E1 commence à se propager dans le circuit. Le circuit C', C" bloque la propagation du signal d'entrée E0, E1 vers la porte logique G0, G1 correspondante si le terminal de la branche n'est pas revenu dans son état initial.

En effet, à la fin d'un cycle, les terminaux de la fourche sont sensés revenir dans leur état initial avant le commencement d'un nouveau cycle. Le terminal d'une branche rapide peut avoir atteint cet état initial et initier un nouveau cycle par l'intermédiaire du signal E0ack ou E1 ack. Par contre, le terminal d'une branche lente peut ne pas l'avoir atteint lorsque la nouvelle donnée est envoyée.

A titre d'exemple, on considère un premier cycle dans lequel le signal d'entrée transmis est E0. A la fin de ce cycle, le signal E0 est dans un état invalide et le signal Sack passe dans un état inactif (phase 4). On suppose alors que le signal Sack se propage uniquement dans la branche B0 jusqu'au terminal X0 (la branche B1 est lente). La porte G0 bascule et le signal E0ack est désactivé.

Un deuxième cycle commence alors par l'envoi d'une nouvelle donnée. Si le signal E1 est choisi comme nouvelle donnée, il se retrouvera bloqué par le circuit C" si le terminal X1 n'a toujours pas commuté, c'est-à-dire s'il n'a pas atteint le même état que le terminal X0.

En d'autres termes, le circuit de blocage C' ou C" interrompt la propagation du signal d'entrée E0 ou E1 vers la porte G0 ou G1 correspondante tant que les terminaux ne sont pas tous revenus dans le même état de fin de cycle. Le blocage ne peut avoir lieu que dans le cas d'un changement du signal de données d'un cycle à l'autre (E0 puis E1, ou inversement).

Ainsi, les circuits de blocage empêchent le basculement prématuré d'une des portes G0 et G1 lorsqu'une nouvelle donnée est demandée et que la branche correspondante n'a pas encore commuté. Le signal d'acquittement E0ack ou E1ack, en sortie de la porte G0 ou G1, est par conséquent retardé.

La complexité du circuit est augmentée de seulement $n$ portes de Muller à deux entrées et une sortie, soit 3n entrées/sorties supplémentaires dans le circuit. La pénalité en vitesse dans le chemin de données est nulle puisque la commutation des portes C' et C" s'effectue en parallèle du traitement de données E0 et E1.

Les figures 15 à 17 représentent un mode de réalisation préférentiel de circuit asynchrone dans lequel les signaux X0' et X1' dérivés par les circuits 2a et 2b sont des copies inversées des terminaux X0 et X1. Pour se faire, on introduit un inverseur dans le circuit de dérivation 2a ou 2b de chaque terminal. Cet inverseur est avantageusement placé au niveau des portes logiques G0 et G1.

Dans le cas des circuits DMUX (Fig.15) et BUFFER (Fig.16), cela revient à déplacer les inverseurs situés dans le circuit de blocage au niveau des portes logiques G0 et G1.

Dans le cas du circuit MERGE (Fig.17), un inverseur peut également être introduit au niveau des portes G0 et G1. Par contre, il est nécessaire dans ce cas de modifier les portes de Muller C' et C". Il faut notamment remplacer le signal de réinitialisation R par un signal d'initialisation R' qui force sa sortie à '1'($Z = R' \cdot X0' \cdot E0 + (X0'+E0) \cdot Z$).

Dans ce mode de réalisation préférentiel, chaque inverseur pourra être intégré directement dans la porte de Muller G0 ou G1 à laquelle il est rattaché, pour ne former qu'une seule porte logique optimisée. Cette porte logique présentera alors une sortie supplémentaire, qui génère une copie inversée du terminal présenté à son entrée.

Une autre solution consiste à ne pas créer de porte spécifique, mais à contraindre le placement de l'inverseur au niveau de la porte de Muller G0, G1 pour que ceux-ci soient adjacents.

Le fait de disposer un inverseur au niveau de chaque porte logique G0, G1 facilite grandement la réalisation de la porte logique et donc la réalisation du circuit. En effet, il est plus facile de créer, avec les outils de CAO usuels, une porte de Muller qui inverse l'une de ses entrées plutôt qu'une porte de Muller qui recopie simplement l'une de ses entrées.

Pour simplifier encore la conception du circuit, il peut être avantageux de réunir la porte « ET » de la figure 15 avec la porte de Muller C, ou la porte « NON-OU » de la figure 16 avec la porte de Muller C, en une seule porte logique optimisée.

La première technique de conception de circuit asynchrone robuste a, jusqu'à présent, été décrite en relation avec une fourche à deux branches. Toutefois, celle-ci peut être étendue et appliquée à des fourches isochrones avec un nombre plus important de branches.

A titre d'exemple, le circuit de la figure 18 met en oeuvre la fonction de démultiplexage pour une fourche à quatre branches. Le circuit de blocage comporte alors plusieurs portes de Muller C, ici au nombre de quatre. Les différentes portes C forment une chaîne qui regroupe les signaux dérivés X0' à X3' en un seul signal, noté X' sur la figure 18.

La dernière porte C de la chaîne est disposée dans le chemin d'acquittement du circuit DMUX et reçoit le signal d'acquittement Sack' à bloquer. Celui-ci résulte de la combinaison de quatre signaux d'acquittement de sortie S0ack à S3ack.

Cette première technique, décrite au travers de trois exemples de fonction logique, garantit le fonctionnement d'un circuit asynchrone quelque soit la dispersion des temps de propagation entre les branches de ses fourches. Aucune hypothèse temporelle n'est formulée. Au contraire, la notion même de fourche isochrone est supprimée. Les circuits asynchrones construits à partir de ces exemples sont donc aussi robustes que des circuits insensibles aux délais.

Par ailleurs, cette technique peut être appliquée à n'importe quelle fourche isochrone, notamment aux fourches d'un circuit qui ne réalise pas l'une des trois fonctions évoquées ci-dessus. Elle permet donc de générer n'importe quel circuit asynchrone robuste aux variations de délais. En outre, elle autorise l'utilisation d'amplificateurs de signaux dans les branches des fourches, sans se soucier des déséquilibres temporels introduits par ces amplificateurs.

Une deuxième technique pour réaliser un circuit asynchrone robuste consiste à contraindre le placement des portes logiques G0 et G1 de la fourche. Dans ce cas, on n'agit pas sur le schéma logique du circuit mais sur la manière dont sont positionnées les portes du circuit les unes par rapport aux autres (étape de placement/routage dans le flot de conception).

Cette technique consiste à réduire la distance entre chaque porte logique et le noeud N de la fourche. Les portes logiques G0 et G1 sont alors regroupées dans une zone restreinte du circuit, de préférence centrée par rapport au noeud N de la fourche, de sorte que la dispersion des temps de propagation entre les branches de la fourche soit aussi faible que possible. La figure 19 est un exemple de fourche F dont le placement des portes logiques G0-G3 a été optimisé. Les portes G0-G3 sont, de préférence, placées à équidistance du noeud N de la fourche. Par équidistance, on entend que les distances de Manhattan entre le noeud N et chaque porte G0-G3 sont sensiblement identiques.

La figure 20 représente la répartition des fourches isochrones du circuit de la figure 8, en fonction de la dispersion de délais dans ses fourches isochrones, après avoir appliqué la technique de placement décrite ci-dessus pour toutes les fourches isochrones jugées déséquilibrées.

On constate que, désormais, toutes les fourches isochrones du circuit ont une différence de délais entre leurs branches inférieure ou égale à 1 ps. Le risque de dysfonctionnement de ces fourches est donc considérablement réduit, voire nul, puisque le mou calculé pour ce circuit ne peut être inférieur à 1 ps. En effet, le mou est au minimum égal au temps de propagation dans une porte, qui pour ce circuit est de l'ordre de 20 à 30 ps.

Chacune des ces techniques de conception peut être utilisée séparément. Dans la pratique, la première technique donne les meilleurs résultats car elle supprime totalement le risque de dysfonctionnement. Toutefois, pour un circuit asynchrone comprenant plusieurs milliers (voire dizaine de milliers) de fourches isochrones, il peut être difficile de l'appliquer à toutes les fourches.

On propose maintenant une méthodologie de conception de circuit asynchrone, qui permet d'obtenir un bon compromis entre la robustesse du circuit vis-à-vis des variations de délais et la simplicité de réalisation du circuit. Cette méthodologie met en oeuvre les deux techniques susmentionnées conjointement.

La méthode consiste, dans un premier temps, à identifier les fourches déséquilibrées, c'est-à-dire susceptibles d'introduire une erreur, et à déterminer leur niveau de dangerosité.

Les fourches sont ensuite classées selon leur niveau de dangerosité. Le niveau de dangerosité de chaque fourche peut être défini en mesurant la dispersion maximale des temps de propagation entre les branches de chaque fourche (soit la différence entre le temps de propagation le plus long et le temps de propagation le plus court) puis en comparant cette dispersion maximale à un seuil. Ce seuil dépend, de préférence, du mou autorisé par le circuit. Il est, par exemple, égal à deux fois le mou minimum du circuit.

Lorsque la dispersion de délais d'une fourche est supérieure au seuil, sa dangerosité pour le fonctionnement du circuit est considérée comme élevée. Elle est alors considérée comme une fourche de première classe et doit être rendue insensible aux délais. On appliquera alors la technique décrite en relation avec les figures 9 à 18, qui consiste à introduire des circuits de dérivation des terminaux et un circuit de blocage.

Lorsque la dispersion de délais d'une fourche est inférieure au seuil, celle-ci est affectée à une deuxième classe d'importance moindre. La fourche est jugée peu dangereuse. La technique de placement décrite en relation avec la figure 19 sera réservée à ces fourches de dangerosité plus faible.

Ainsi, en plus de supprimer l'hypothèse d'isochronie dans certaines fourches, on pourra contraindre le placement des portes logiques dans d'autres fourches déséquilibrées, mais qui présentent un risque de dysfonctionnement moindre.

Bien entendu, lorsque la dispersion de délais est inférieure au mou minimum, il est possible de ne pas modifier la fourche. En pratique, on prévoit une marge de sécurité, par exemple 20 % du mou minimum, pour compenser les éventuelles variations des temps de propagation pendant le fonctionnement du circuit. Ainsi, seules les fourches ayant une dispersion de délais supérieure à 0,8 fois le mou minimum seront modifiées selon l'une des deux techniques enseignées ci-dessus.

Lorsqu'il n'est pas possible de mesurer la dispersion de délais entre les branches, le niveau de dangerosité d'une fourche peut être déterminé seulement en connaissance du mou ou de la marge temporelle du circuit associé à cette fourche. Le mou est ensuite comparé à un seuil prédéfini. Par exemple, pour un mou inférieur à 30 ps, le niveau de dangerosité est élevé et la fourche appartient à la première classe, et pour un mou supérieur à 30 ps, le niveau de dangerosité est faible et la fourche appartient à la deuxième classe.

Pour évaluer le mou, on détermine le nombre de portes logiques qui le caractérisent, c'est-à-dire le nombre de portes qu'un signal traverse avant de causer un dysfonctionnement, puis on additionne leurs délais de propagation moyens.

D'autres variantes et modifications des circuits asynchrones décrits ici apparaitront à l'homme du métier. On pourrait notamment concevoir les circuits DMUX, MERGE et BUFFER de différentes façons. Les états logiques des signaux pourraient par exemple être tous inversés sans modifier le fonctionnement de ces circuits.

Les techniques de conception ci-dessus ont été décrites en relation avec un protocole de communication quatre phases. Toutefois, des circuits asynchrones robustes, basés sur un protocole deux phases, peuvent aussi être obtenus en appliquant ces techniques.

## Revendications

1.  Circuit asynchrone comprenant une fourche (F) à au moins deux branches (B0, B1), chaque branche étant connectée à une porte logique (G0, G1) de sorte que la porte logique reçoive en entrée un signal de fin de branche (X0, X1), **caractérisé en ce qu'il** comporte :

    - un circuit de dérivation (2a, 2b) du signal de fin de branche (X0, X1) au niveau de chaque porte logique pour former un signal dérivé (X0', X1'), et
    - un circuit de blocage comprenant une porte de Muller (C, C', C'', G0, G1) et recevant en entrée au moins un signal dérivé (X0', X1'), le circuit de blocage étant configuré pour empêcher la propagation d'un signal de sortie (Eack, E0ack, E1ack, S0, S1) lorsque les signaux de fin de branche (X0, X1) sont dans des états logiques différents.

2.  Circuit asynchrone selon la revendication 1, dans lequel le circuit de blocage est distinct de chaque porte logique (G0, G1).

3.  Circuit asynchrone selon l'une des revendications 1 et 2, dans lequel le circuit de blocage reçoit tous les signaux de fin de branche (X0, X1) dont au moins un est dérivé par un circuit de dérivation (2a, 2b).

4.  Circuit asynchrone selon la revendication 3, dans lequel le circuit de blocage reçoit en entrée tous les signaux dérivés (X0', X1') et un signal à bloquer (Sack'), le signal de sortie étant un signal d'acquittement (Eack).

5.  Circuit asynchrone selon la revendication 1, comportant un circuit de blocage pour chaque porte logique (G0, G1), chaque circuit de blocage comprenant une porte de Muller (C', C'') et recevant en entrée le signal dérivé (X0', X1') associé à la porte logique et un signal de données à bloquer (E0, E1), la sortie du circuit de blocage étant reliée à une entrée de la porte logique.

6.  Circuit asynchrone selon l'une quelconque des revendications 1 à 5, dans lequel chaque signal dérivé (X0', X1') est une copie du signal de fin de branche associé (X0, X1).

7.  Circuit asynchrone selon l'une quelconque des revendications 1 à 5, dans lequel chaque signal dérivé (X0', X1') est une copie inversée du signal de fin de branche associé (X0, X1).

8.  Circuit asynchrone selon la revendication 7, comprenant un inverseur au niveau de chaque porte logique (G0, G1).

9.  Procédé pour réduire la sensibilité aux délais d'un circuit asynchrone, comprenant les étapes suivantes :

    • fournir une première fourche isochrone (F1) ayant un premier niveau de dangerosité et comprenant au moins deux branches (B0, B1) connectées chacune à une porte logique (G0, G1) ;
    • introduire un circuit de dérivation (2a, 2b) du signal de fin de branche (X0, X1) au niveau de chaque porte logique pour former un signal dérivé (X0', X1') ; et
    • fournir un circuit de blocage (C, C', C'', G0, G1) comprenant une porte de Muller, recevant en entrée au moins un signal dérivé (X0', X1') et configuré pour empêcher la propagation d'un signal de sortie (Eack, E0ack, E1ack, S0, S1) lorsque les signaux de fin de branche (X0, X1) sont dans des états logiques différents.

10. Procédé selon la revendication 9, comprenant les étapes suivantes :

    • fournir une deuxième fourche isochrone (F2) ayant un deuxième niveau de dangerosité, inférieur au premier niveau de dangerosité, et comprenant au moins deux branches (B0, B1) connectées chacune à une porte logique (G0, G1) ; et
    • disposer les portes logiques associées à la deuxième fourche dans une zone restreinte du circuit, de manière à limiter la dispersion des temps de propagation entre les branches de la deuxième fourche.

11. Procédé selon la revendication 10, dans lequel les premier et deuxième niveaux de dangerosité sont déterminés en mesurant la dispersion maximale des temps de propagation entre les branches de chaque fourche isochrone et en comparant la dispersion maximale à un seuil.

12. Procédé selon la revendication 10, dans lequel les premier et deuxième niveaux de dangerosité sont déterminés en évaluant la marge temporelle du circuit asynchrone et en comparant la marge temporelle à un seuil.

**Patentansprüche**

1. Asynchroner Schaltkreis, umfassend eine Gabel (F) mit wenigstens zwei Zweigen (B0, B1), wobei jeder Zweig an ein Logikgatter (G0, G1) angeschlossen ist, so dass das Logikgatter eingangseitig ein Zweigendsignal (X0, X1) empfängt, **dadurch gekennzeichnet, dass** er umfasst:

   - einen Kreis zum Abzweigen (2a, 2b) des Zweigendsignals (X0, X1) im Bereich eines jeden Logikgatters, um ein abgezweigtes Signal (X0', X1') zu bilden, und
   - eine Sperrschaltung, die ein Muller-Element (C, C', C", G0, G1) umfasst und eingangseitig wenigstens ein abgezweigtes Signal (X0', X1') empfängt, wobei die Sperrschaltung dazu ausgelegt ist, die Ausbreitung eines Ausgangssignals (Eack, E0ack, E1ack, S0, S1) zu verhindern, wenn die Zweigendsignale (X0, X1) sich in unterschiedlichen logischen Zuständen befinden.

2. Asynchroner Schaltkreis nach Anspruch 1, wobei die Sperrschaltung von jedem Logikgatter (G0, G1) getrennt ist.

3. Asynchroner Schaltkreis nach einem der Ansprüche 1 und 2, wobei die Sperrschaltung alle Zweigendsignale (X0, X1) empfängt, von denen wenigstens eines durch einen Abzweigkreis (2a, 2b) abgezweigt ist.

4. Asynchroner Schaltkreis nach Anspruch 3, wobei die Sperrschaltung eingangseitig alle abgezweigten Signale (X0', X1') und ein zu blockierendes Signal (Sack') empfängt, wobei das Ausgangssignal ein Quittiersignal (Eack) ist.

5. Asynchroner Schaltkreis nach Anspruch 1, umfassend eine Sperrschaltung für jedes Logikgatter (G0, G1), wobei jede Sperrschaltung ein Muller-Element (C', C") umfasst und eingangseitig das abgezweigte Signal (X0', E1'), das dem Logikgatter zugeordnet ist, und ein zu blockierendes Datensignal (E0, E1) empfängt, wobei der Ausgang der Sperrschaltung mit einem Eingang des Logikgatters verbunden ist.

6. Asynchroner Schaltkreis nach einem der Ansprüche 1 bis 5, wobei jedes abgezweigte Signal (X0', X1') eine Kopie des zugeordneten Zweigendsignals (X0, X1) ist.

7. Asynchroner Schaltkreis nach einem der Ansprüche 1 bis 5, wobei jedes abgezweigte Signal (X0', X1') eine umgekehrte Kopie des zugeordneten Zweigendsignals (X0, X1) ist.

8. Asynchroner Schaltkreis nach Anspruch 7, umfassend einen Inverter im Bereich eines jeden Logikgatters (G0, G1).

9. Verfahren zur Verringerung der Verzögerungsempfindlichkeit eines asynchronen Schaltkreises, umfassend die folgenden Schritte:

   • Bereitstellen einer ersten isochronen Gabel (F1), die eine erste Gefährlichkeitsstufe aufweist und wenigstens zwei Zweige (B0, B1), welche jeweils an ein Logikgatter (G0, G1) angeschlossen sind, umfasst,
   • Einführen eines Kreises zum Abzweigen (2a, 2b) des Zweigendsignals (X0, X1) im Bereich eines jeden Logikgatters, um ein abgezweigtes Signal (X0', X1') zu bilden, und
   • Bereitstellen einer Sperrschaltung (C, C', C", G0, G1), die ein Muller-Element umfasst, eingangseitig wenigstens ein abgezweigtes Signal (X0', X1') empfängt und dazu ausgelegt ist, die Ausbreitung eines Ausgangssignals (Eack, E0ack, E1ack, S0, S1) zu verhindern, wenn die Zweigendsignale (X0, X1) sich in unterschiedlichen logischen Zuständen befinden.

10. Verfahren nach Anspruch 9, umfassend die folgenden Schritte:

   • Bereitstellen einer zweiten isochronen Gabel (F2), die eine zweite Gefährlichkeitsstufe, welche unter der ersten Gefährlichkeitsstufe liegt, aufweist und wenigstens zwei Zweige (B0, B1), welche jeweils an ein Logikgatter (G0, G1) angeschlossen sind, umfasst, und
   • Anordnen der der zweiten Gabel zugeordneten Logikgatter in einem begrenzten Bereich des Schaltkreises, um die Streuung der Laufzeiten zwischen den Zweigen der zweiten Gabel zu begrenzen.

11. Verfahren nach Anspruch 10, wobei die erste und die zweite Gefährlichkeitsstufe dadurch bestimmt werden, dass die maximale Streuung der Laufzeiten zwischen den Zweigen einer jeden isochronen Gabel gemessen und die maximale Streuung mit einem Schwellwert verglichen wird.

12. Verfahren nach Anspruch 10, wobei die erste und die zweite Gefährlichkeitsstufe dadurch bestimmt werden, dass die Zeitspanne des asynchronen Schaltkreises bewertet und die Zeitspanne mit einem Schwellwert verglichen wird.

**Claims**

1.  Asynchronous circuit comprising a fork (F) having at least two branches (B0, B1), each branch being connected to a logic gate (G0, G1) so that the logic gate receives as input a branch-ending signal (X0, X1), **characterized in that** it comprises:

    - a circuit (2a, 2b) for branching the branch-ending signal (X0, X1) at the level of each logic gate to form a branched signal (X0', X1'), and
    - a blocking circuit comprising a Muller gate (C, C', C", G0, G1) and receiving as input at least one branched signal (X0', X1'), the blocking circuit being configured to prevent the propagation of an output signal (Eack, E0ack, E1ack, S0, S1) when the branch-ending signals (X0, X1) are in different logic states.

2.  Asynchronous circuit according to claim 1, wherein the blocking circuit is separate from each logic gate (G0, G1).

3.  Asynchronous circuit according to any of claims 1 and 2, wherein the blocking circuit receives all branch-ending signals (X0, X1), one at least being branched by a branching circuit (2a, 2b).

4.  Asynchronous circuit according to claim 3, wherein the blocking circuit receives as input all the branched signals (X0', X1') and a signal to be blocked (Sack'), the output signal being an acknowledgement signal (Eack).

5.  Asynchronous circuit according to claim 1, comprising a blocking circuit for each logic gate (G0, G1), each blocking circuit comprising a Muller gate (C', C") and receiving as input the branched signal (X0', X1') associated with the logic gate and a data signal to be blocked (E0, E1), the output of the blocking circuit being connected to an input of the logic gate.

6.  Asynchronous circuit according to any one of claims 1 to 5, wherein each branched signal (X0', X1') is a copy of the associated branch-ending signal (X0, X1).

7.  Asynchronous circuit according to any one of claims 1 to 5, wherein each branched signal (X0', X1') is an inverted copy of the associated branch-ending signal (X0, X1).

8.  Asynchronous circuit according to claim 7, comprising an inverter at the level of each logic gate (G0, G1).

9.  Method for decreasing the delay sensitivity of an asynchronous circuit, comprising the steps of:

    • providing a first isochronic fork (F1) having a first level of danger and comprising at least two branches (B0, B1), each connected to a logic gate (G0, G1);
    • introducing a circuit (2a, 2b) for branching the branch-ending signal (X0, X1) at the level of each logic gate to form a branched signal (X0', X1'); and
    • providing a blocking circuit (C, C', C", G0, G1) comprising a Muller gate, receiving as input at least one branched signal (X0', X1') and configured to prevent the propagation of an output signal (Eack, E0ack, E1ack, S0, S1) when the branch-ending signals (X0, X1) are in different logic states.

10. Method according to claim 9, comprising the steps of:

    • providing a second isochronic fork (F2) having a second level of danger, lower than the first level of danger, and comprising at least two branches (B0, B1), each connected to a logic gate (G0, G1); and
    • arranging the logic gates associated with the second fork in a limited area of the circuit, so as to limit the propagation delay dispersion between the branches of the second fork.

11. Method according to claim 10, wherein the first and second levels of danger are determined by measuring the maximum propagation time dispersion between the branches of each isochronic fork and by comparing the maximum dispersion with a threshold.

12. Method according to claim 10, wherein the first and second levels of danger are determined by assessing the time margin of the asynchronous circuit and by comparing the time margin with a threshold.

FIG. 1 (art antérieur)

FIG. 2 (art antérieur)

FIG. 3 (art antérieur)

Cack      C0  C1

Eack

G0      S0

E            S0ack
S1ack

G1      S1

**FIG. 4 (art antérieur)**

Cack      C0  C1

Eack   X0

G0    S0

E       S0ack
S1ack

X1

G1    S1

**FIG. 5 (art antérieur)**

Cack      C0  C1

Eack

G0    S0

E       S0ack
S1ack

G1    S1

**FIG. 6 (art antérieur)**

13

**FIG. 7 (art antérieur)**

Différence de délais (en ps)

**FIG. 8 (art antérieur)**

**FIG. 9**

**FIG. 10**

**FIG. 11 (art antérieur)**

**FIG. 12**

**FIG. 13 (art antérieur)**

**FIG. 14**

16

**FIG. 15**

**FIG. 16**

**FIG. 17**

**FIG. 18**

**FIG. 19**

Différence de délais (en ps)

**FIG. 20**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4845633 A